# FASCICULE DE BREVET EUROPEEN

(11) **EP 3 772 113 B1**
(45) Date de publication et mention de la délivrance du brevet: **01.06.2022**
(21) Numéro de dépôt: 20188319.6
(22) Date de dépôt: 29.07.2020
(51) Int. Cl.: H01L 31/042, H02S 20/26, H02S 20/32

(54) **MODULE PHOTOVOLTAÏQUE, PROCÉDÉ DE FABRICATION ET SYSTÈME D'INTÉGRATION ASSOCIÉS**
FOTOVOLTAIKMODUL, ENTSPRECHENDES HERSTELLUNGSVERFAHREN UND INTEGRATIONSSYSTEM
PHOTOVOLTAIC MODULE, ASSOCIATED MANUFACTURING METHOD AND INTEGRATION SYSTEM

(30) Priorité: 31.07.2019 FR 1908758
(43) Date de publication de la demande: 03.02.2021
(73) Titulaire: Commissariat à l'Énergie Atomique et aux Énergies Alternatives, 75015 Paris (FR)
(72) Inventeur: THONY, Philippe, 38054 Grenoble Cedex 09 (FR); MESSAOUDI, Paul, 38054 Grenoble Cedex 09 (FR)
(74) Mandataire: Hautier IP

(56) Documents cités:
- EP-A1- 2 020 467
- WO-A1-2009/108159
- US-B1- 7 799 987

## Description

### DOMAINE TECHNIQUE

La présente invention concerne le domaine des composants de façade de bâtiments et infrastructures dont le but est d'apporter protection et confort des utilisateurs et qui possèdent également une capacité de production d'électricité, en particulier en étant associés à des cellules photovoltaïques. Elle trouve pour application particulièrement avantageuse le domaine des composants photovoltaïques intégrés au bâtiment ou BIPV (pour « Building Integrated PhotoVoltaics » selon la terminologie anglo-saxonne).

### ÉTAT DE LA TECHNIQUE

Traditionnellement, le confort d'un bâtiment peut relever de différentes fonctions des composants intégrés sur sa façade. En particulier, ces fonctions comprennent :
a. la protection solaire des occupants, notamment pour la limitation des phénomènes de surchauffe en été, et éviter ainsi l'usage d'un dispositif de climatisation,
b. la garantie du confort visuel des occupants, notamment pour leur éviter d'être éblouis ou pour leur donner une vue sur l'extérieur, et
c. une signature esthétique, notamment extérieure, de la façade.

En outre, les composants peuvent avoir une fonction d'étanchéification et/ou de structuration mécanique de la façade, et peuvent en particulier participer à la résolution de problèmes de portance du bâtiment, de protection contre les intempéries et/ou de sécurité contre diverses intrusions envisageables (du moustique au cambrioleur).

Il existe plusieurs solutions d'intégration de composants photovoltaïques en façade de bâtiment.

Parmi celles-ci, on peut citer la solution développée par l'institut fédéral suisse de technologie à Zurich et connu sous l'appellation commerciale « Adaptive Solar Façade (ASF) ». Cette solution consiste à fixer des modules photovoltaïques rigides à la façade d'un bâtiment par le biais d'une structure porteuse, mécanique et rigide. Chaque module est plus particulièrement monté sur la structure porteuse par le biais d'un actuateur pneumatique permettant de faire varier l'orientation du module. La structure porteuse comprend des câbles métalliques. Par ailleurs, des tuyaux métalliques permettent d'une part d'accueillir des câbles de connexion électrique pour transporter l'énergie électrique générée par les modules vers des dispositifs extérieurs de transformation de cette énergie, d'autre part de commander les actuateurs pneumatiques. Lorsque la façade du bâtiment est une surface vitrée, l'on comprend que la mobilité de chaque module et le report à distance du traitement de l'énergie électrique produite permettent de gérer, non seulement la production électrique, mais également le confort du bâtiment, en laissant passer plus ou moins d'énergie lumineuse à l'intérieur du bâtiment via la façade vitrée et en s'orientant en fonction de la position du soleil.

Les cellules photovoltaïques de tels modules photovoltaïques peuvent être des cellules organiques, et sont souvent à base de silicium ou à base de couche mince, par exemple de CIGS, mais peuvent être issues de n'importe quelle technologie *ad hoc.* Elles sont encapsulées entre deux feuilles de matériaux. Elles doivent être protégées des agressions extérieures (humidité, produits corrosifs, éléments météorologiques) pour leur garantir un fonctionnement sur une longue durée et une certaine stabilité mécanique, voire une certaine rigidité.

Notamment afin de protéger les cellules, mais également afin d'augmenter la rigidité du module et de permettre sa fixation sur la structure porteuse, chaque module peut également comprendre une face avant transparente, généralement en verre, et une face arrière imperméable, par exemple constituée en verre ou en un film à base de polymère et/ou de métal, le substrat encapsulant les cellules photovoltaïques étant pris en sandwich entre la face avant et la face arrière.

Chaque module peut en outre comprendre un cadre, notamment afin d'en renforcer encore la rigidité et permettre sa fixation sur la structure porteuse. Il est toutefois souvent souhaité que les modules ne comprennent pas de cadre, par exemple afin que leur juxtaposition bord à bord confère, à la façade du bâtiment, une fonction esthétique améliorée. Ainsi, si la présence d'un cadre est en général nécessaire, il est possible de l'éviter :
a. si le module sans cadre présente une rigidité suffisante. Ce sera le cas notamment d'un module dit en verre-polymère présentant une épaisseur de verre significative eu égard à la surface du module et d'un module dit bi-verre, ou d'un module ayant une face arrière structurée en trois dimensions ; et
b. si le module sans cadre est un module souple ou flexible par conception dans la mesure où il est assemblé sur un composant d'enveloppe, par exemple par collage.

Des systèmes mécaniques existent pour le montage des modules sans cadre, tels que les pinces à mâchoires. Ces dernières viennent pincer les deux faces du module sur le bord, souvent en mettant en oeuvre une vis de serrage. Elles sont garnies d'un matériau souple pour ne pas endommager le verre qui constitue les faces extérieures du module. Plusieurs pinces peuvent être utilisées pour fixer un module sur la structure porteuse ou sur l'enveloppe du bâtiment.

Une autre solution de fixation de modules sans cadre est basée sur l'utilisation de pièces collées sur la face arrière du module et configurées pour être assemblées sur les pièces complémentaires de la structure porteuse ou de l'enveloppe du bâtiment.

Il est également à noter que les modules sans cadre sont par ailleurs moins contraints en termes de forme. En effet, les modules avec cadre sont généralement rectangulaires, car contraints par le cadre particulier lorsque ce dernier est fabriqué avec des profilés métalliques. Ainsi, la forme des modules peut plus facilement être adaptée à la volonté du concepteur et de l'architecte du bâtiment. Toutefois, la forme des modules, avec ou sans cadre, est souvent limitée, voire imposée, par la chaîne de fabrication dont ils sont issus.

Notons également qu'il existe des modules colorés. Ces modules comprennent un film laminé dont les propriétés sont de donner une couleur au module, lui conférant ainsi un aspect esthétique, tout en laissant passer le rayonnement solaire à capter. Le film est donc plus particulièrement laminé au-dessus des cellules dans l'empilement constituant le module, voire sur la face avant du module, par exemple sur la feuille de verre d'une telle face avant. La face avant vu de l'extérieur est alors dominée par la couleur du film. Il peut aussi s'agir d'un film laminé présentant ou dessinant un motif, uni ou non, monochrome ou polychrome, répétitif, figuratif. Il peut alors s'agir d'une image figurative ou d'une imitation d'un matériau de construction. Il peut aussi s'agir d'une ou plusieurs couches déposées sur le verre, d'un matériau coloré ou d'un matériau donnant à la/les couches des propriétés optiques particulières (une propriété de filtre interférentiel par exemple). Ainsi, la couleur et le motif de chaque film permet d'adapter les modules à la volonté du concepteur et de l'architecte du bâtiment. Toutefois, le procédé de lamination du module doit être modifié en conséquence pour obtenir une bonne qualité mécanique de l'ensemble.

Notons encore qu'il existe des modules intégrant un tissu dans le substrat encapsulant les cellules photovoltaïques. Le tissu est par exemple imprégné par le polymère constituant le substrat. De tels modules peuvent en particulier présenter l'avantage d'être légers et souples. Plus particulièrement, il existe des tissus de fibres polymère imprégnées de polymère thermiquement réticulable. Le tissu est en général contenu à l'intérieur du module entre ses faces avant et arrière.

Les documents EP 2 020 467 A1, WO 2009/108159 A1 et US 7 799 987 B1 décrivent des modules photovoltaïques montés sur des substrats souples.

Un objet de la présente invention est de proposer une solution d'intégration de composants photovoltaïques au bâtiment qui pallie au moins des inconvénients des solutions antérieures.

Un autre objet de la présente invention est de proposer une solution alternative, voire meilleure, pour l'intégration de composants photovoltaïques au bâtiment.

Un autre objet de la présente invention est de proposer une solution moins coûteuse que les solutions antérieures pour l'intégration de composants photovoltaïques au bâtiment.

Un autre objet de la présente invention est de proposer une solution d'intégration de composants photovoltaïques au bâtiment qui présente un aspect esthétique amélioré, voire modulable.

Un autre objet de la présente invention est de proposer une solution d'intégration de composants photovoltaïques au bâtiment qui maximise la production électrique, maximise le confort thermique dans le bâtiment ou l'espace entre la face arrière des modules et la façade du bâtiment, offrir une protection des occupants contre l'éblouissement par l'ensoleillement direct, et/ou permettre d'atteindre une configuration globale répondant à une esthétique particulière à l'échelle de la façade du bâtiment.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre cet objectif, l'invention prévoit, selon un premier de ses aspects, un module photovoltaïque comprenant :
- un substrat, et
- une pluralité de cellules photovoltaïques encapsulées dans le substrat, le module présentant :
- une première partie comprenant les cellules photovoltaïques réparties en au moins deux sous-modules photovoltaïques disjoints entre eux, et
- une deuxième partie exempte de cellules photovoltaïques et s'étendant depuis la première partie du module pour former un organe de liaison joignant entre eux les sous-modules photovoltaïques.

L'organe de liaison, au moins en partie formé par le substrat, est configuré pour être monté sur une structure porteuse et pour présenter une souplesse telle qu'une déformation de l'organe de liaison induise un mouvement d'au moins l'un, de préférence de plusieurs, potentiellement de chacun, des sous-modules photovoltaïques, sans déformation des sous-modules photovoltaïques, ledit mouvement étant fonction de la déformation de l'organe de liaison.

Le module est en outre tel que, l'organe de liaison s'étendant selon une direction principale D déterminée, la déformation de l'organe de liaison comprend une torsion de l'organe de liaison avec un moment de force agissant dans ladite direction principale D.

De manière facultative, le module photovoltaïque selon le premier aspect de l'invention peut en outre présenter au moins l'une quelconque des caractéristiques suivantes :
a. l'organe de liaison comprend au moins une pluralité de protrusions s'étendant chacune depuis un sous-module photovoltaïque et une partie formant un mât dont au moins une des deux extrémités est configurée pour être montée sur la structure porteuse, chaque protrusion s'étendant le cas échéant jusqu'à joindre le mât, et
b. l'organe de liaison a une fonction de liaison mécanique des sous-modules entre eux et une fonction de liaison électrique des cellules photovoltaïques entre elles et/ou des sous-modules entre eux.

Le module photovoltaïque 1 selon le premier aspect de l'invention est d'une simplicité de conception avantageuse, mais se distingue également des solutions antérieures de par sa simplicité de fabrication, qui révèle son faible coût.

Un deuxième aspect concerne un procédé de fabrication d'un module photovoltaïque tel qu'introduit ci-dessus, ledit procédé comprenant une unique étape de lamination configurée pour encapsuler les cellules photovoltaïques dans le substrat et pour former au moins lesdites première et deuxième parties du module photovoltaïque.

Le procédé de fabrication selon le deuxième aspect de l'invention est avantageusement simple et viable industriellement. Il permet d'atteindre une grande modularité d'intégration du système 10 offrant autant d'opportunités aux concepteurs de façade de bâtiment de se distinguer.

Un troisième aspect de l'invention concerne un système d'intégration de composants photovoltaïques à un bâtiment, de préférence à une façade de bâtiment, comprenant une pluralité de modules photovoltaïques tels qu'introduits ci-dessus, et une structure porteuse destinée à être fixée sur le bâtiment, de préférence sur la façade de bâtiment.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente schématiquement une vue en perspective d'un système d'intégration selon un mode de réalisation de la présente invention.
La figure 1A représente schématiquement une vue de dessus en transparence d'une partie du système d'intégration représenté par la figure 1.
La figure 2 représente schématiquement une vue partielle et en perspective d'un système d'intégration selon un autre mode de réalisation que celui représenté sur la figure 1.
Les figures 3 à 5 représentent schématiquement une vue de face d'une partie d'un module selon des différents modes de réalisation de l'invention.
La figure 6 représente schématiquement une vue de face d'un module photovoltaïque selon l'art antérieur.
Les figures 7 à 9 représentent schématiquement une vue de face d'une partie d'un module selon différents modes de réalisation de l'invention.
La figure 10 représente schématiquement une vue de face d'une partie au moins d'un produit intermédiaire du procédé de fabrication d'un module selon un mode de réalisation de l'invention.
La figure 11 représente schématiquement une vue de face d'une partie au moins d'un produit intermédiaire du procédé de fabrication d'un module selon un autre mode de réalisation de l'invention que celui illustré sur la figure 10.
La figure 12 représente schématiquement une vue de face de plusieurs modules selon un mode de réalisation de l'invention configurés entre eux selon un premier modèle d'intégration interdigitée.
La figure 13 représente schématiquement une vue de face de plusieurs modules selon un autre mode de réalisation de l'invention que celui illustré sur la figure 12, configurés entre eux selon un deuxième modèle d'intégration interdigitée.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

### DESCRIPTION DÉTAILLÉE

Avant d'entamer une revue détaillée de modes de réalisation du premier aspect de l'invention, sont énoncées ci-après des caractéristiques optionnelles qui peuvent éventuellement être utilisées en association ou alternativement.

Les sous-modules photovoltaïques peuvent être entièrement supportés par l'organe de liaison. Plus particulièrement, l'organe de liaison peut être d'une rigidité suffisante pour supporter les sous-modules.

Le module photovoltaïque peut délimiter un espace dépourvu de matière entre deux sous-modules photovoltaïques adjacents.

Le module photovoltaïque peut présenter une forme sensiblement plane en l'absence de déformation de l'organe de liaison.

Deux sous-modules adjacents peuvent être disposés au droit l'un de l'autre en l'absence de déformation de l'organe de liaison.

Les sous-modules photovoltaïques peuvent présenter une même surface et/ou une même géométrie et/ou un même nombre de cellules photovoltaïques.

De préférence, les sous-modules photovoltaïques sont identiques entre eux.

Le substrat peut être sensiblement plan en l'absence de déformation de l'organe de liaison.

Le mouvement d'au moins l'un, de préférence de chacun, des sous-modules photovoltaïques peut être induit de façon répétable par la déformation de l'organe de liaison.

Une déformation donnée de l'organe de liaison peut induire un changement de position relative d'au moins un sous-module, de préférence de plusieurs sous-modules, potentiellement de chaque sous-module, par rapport aux autres sous-modules du module photovoltaïque et par rapport à la structure porteuse.

Chaque sous-module peut être suffisamment rigide pour ne pas être déformé par la déformation de l'organe de liaison.

L'organe de liaison peut être configuré, en termes de matière, de dimensions et de forme, pour supporter les sous-modules sans se déformer sous leur seul poids.

Pour une même déformation de l'organe de liaison, le mouvement d'au moins un sous-module, voire de chaque sous-module, peut être différent, mais dépendant, d'un mouvement d'un autre sous-module (2A, 2B, etc.), voire de chaque autre sous-module.

Le module photovoltaïque peut être configuré de sorte qu'une déformation en torsion de l'organe de liaison autour de sa direction principale d'extension D entraîne une rotation des sous-modules photovoltaïques autour de cette direction.

L'organe de liaison peut former au moins un mât dont au moins une des deux extrémités est destinée à être montée sur la structure porteuse. Plus particulièrement, l'une au moins des deux extrémités peut être destinée à être montée sur la structure porteuse par l'intermédiaire d'un actuateur configuré pour appliquer une torsion au mât que forme l'organe de liaison.

Le module photovoltaïque peut comprendre en outre des pistes conductrices d'électricité encapsulées dans le substrat et s'étendant entre les première et deuxième parties du module pour relier, entre elles, les cellules photovoltaïques, en série ou en parallèle, et permettre la connexion du module à au moins une connectique extérieure au module telle qu'une boîte de jonction.

Au moins un sous-module, et de préférence chaque sous-module, peut être exempt de l'un au moins parmi :
a. un cadre,
b. une face avant, et
c. une face arrière

En alternative à la caractéristique précédente, au moins un sous-module, et de préférence chaque sous-module, peut comprendre au moins l'une parmi une face avant et une face arrière constituée par exemple de polycarbonate ou d'un matériau pré-imprégné.

Le substrat peut comprendre, ou peut être constitué de, un composite d'un polymère et d'un matériau de renfort, par exemple un tissu à base de polypropylène avec un taux de fibres de verre de 60 % en masse.

La première partie du module peut s'étendre d'un unique côté de la deuxième partie du module. En alternative, la première partie du module peut s'étendre de part et d'autre de la deuxième partie du module.

Le module photovoltaïque peut comprendre en outre au moins deux câbles de renfort sensiblement parallèles entre eux et s'étendant sur toute une longueur de l'organe de liaison, voire au-delà.

L'organe de liaison peut comprendre en outre au moins un élément de contrôle de rigidité locale choisi parmi :
a. Un retrait de matière pour diminuer localement la rigidité de l'organe de liaison,
b. un insert, tel qu'un film, un patch ou une barre, pour augmenter localement la rigidité de l'organe de liaison.

Au moins un sous-module, de préférence chaque sous-module, peut être bifacial.

Au moins une cellule photovoltaïque, de préférence chaque cellule photovoltaïque, peut être une demi-cellule ou une cellule découpée pour présenter une taille inférieure.

Avant d'entamer une revue détaillée de modes de réalisation du deuxième aspect de l'invention, sont énoncées ci-après des caractéristiques optionnelles qui peuvent éventuellement être utilisées en association ou alternativement.

Le procédé de fabrication tel qu'introduit ci-dessus peut comprendre en outre, après l'étape de lamination, une étape de découpage d'au moins une partie du substrat située entre au moins deux sous-modules photovoltaïques adjacents entre eux. L'étape de découpage est de préférence paramétrée de sorte que les sous-modules soient joints entre eux uniquement par l'organe de liaison. L'étape de découpage est paramétrée de sorte qu'au moins une partie à découper soit d'une surface supérieure, par exemple de 10 %, voire de 20 %, à une surface des sous-modules photovoltaïques. En complément ou en alternative, l'étape de découpage est paramétrée de sorte qu'au moins une partie à découper soit d'une surface inférieure, d'au moins un ordre de grandeur, à une surface des sous-modules photovoltaïques.

Avant d'entamer une revue détaillée de modes de réalisation du troisième aspect de l'invention tel qu'introduit ci-dessus, sont énoncées ci-après des caractéristiques optionnelles qui peuvent éventuellement être utilisées en association ou alternativement.

L'organe de liaison d'au moins un module, de préférence de chaque module, forme un mât dont au moins une des deux extrémités est montée sur la structure porteuse. Plus particulièrement, l'une au moins des deux extrémités d'au moins un mât, de préférence de chaque mât, est montée sur la structure porteuse par l'intermédiaire d'un actuateur configuré pour appliquer une torsion au mât que forme l'organe de liaison.

L'organe de liaison pouvant comprendre au moins deux câbles de renfort sensiblement parallèles entre eux et s'étendant sur toute une longueur de l'organe de liaison, voire au-delà, l'organe de liaison peut être monté sur la structure porteuse au moins par les extrémités de chaque câble de renfort.

Chaque sous-module présentant une extrémité libre à l'opposé d'une seconde extrémité par laquelle s'étend l'organe de liaison, le système d'intégration peut comprendre en outre un système de verrouillage du mouvement des extrémités libres des sous-modules entre elles et relativement à la structure porteuse.

Le système d'intégration peut comprendre en outre un mécanisme de compensation de l'étirement subi par l'organe de liaison lors de sa déformation, par exemple par torsion.

Il est précisé que dans le cadre de la présente invention, le terme « souplesse » vise à qualifier la qualité de quelque chose qui est souple, c'est-à-dire quelque chose configuré pour être déformable lorsqu'on lui applique une force de déformation et notamment une torsion. On considère qu'un premier objet est plus souple qu'un second objet lorsque, en appliquant une même force de déformation aux deux objets, le premier se déforme davantage que le second. En particulier, lorsqu'il s'agit de comparer la souplesse de l'organe de liaison et de chacun des sous-modules photovoltaïques décrits ci-dessous, l'on pourra séparer les sous-modules photovoltaïques de l'organe de liaison d'un module photovoltaïque selon n'importe quel mode de réalisation de l'invention, puis appliquer d'une part à chacun des sous-modules, d'autre part à l'organe de liaison, une même force de déformation, notamment en torsion, et constater que l'organe de liaison se déforme davantage que chacun des sous-modules. De préférence, une même force de déformation conduit à une déformation de l'organe de liaison d'une amplitude au moins 10 fois, de préférence au moins 100 fois, supérieure à l'amplitude de la déformation de chacun des sous-modules soumis à la même déformation. La force de déformation à appliquer est ici considérée être telle qu'elle conserve l'intégrité de l'objet déformé, et plus généralement telle qu'elle n'induit pas la dégradation de l'objet déformé.

On entend par un matériau « préimprégné » un matériau constituant un produit semi-fini comprenant une résine (encore appelée matrice) thermodurcissable ou un polymère thermoplastique imprégnant un renfort (exemples : mat, tissu, fibre de verre). Ce composite est de préférence fortement chargé. Il est destiné à être moulé ou laminé à chaud et sous pression pour fabriquer un produit fini.

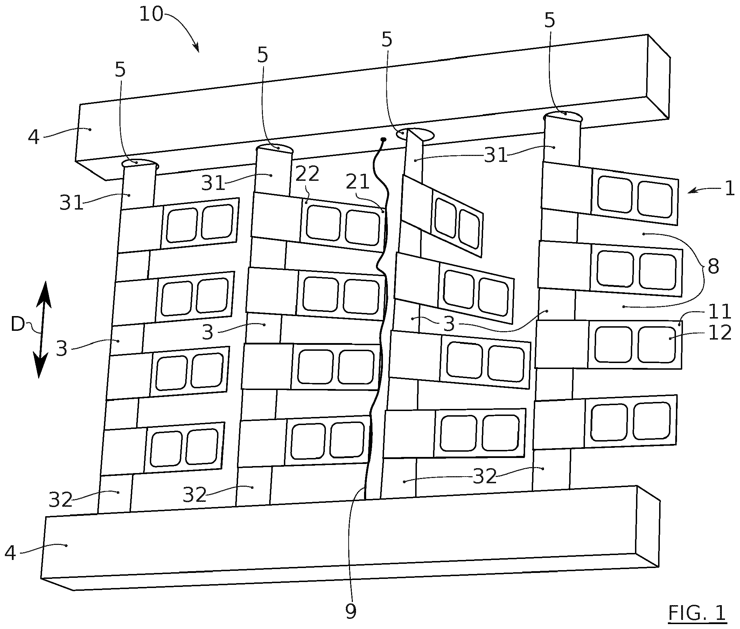

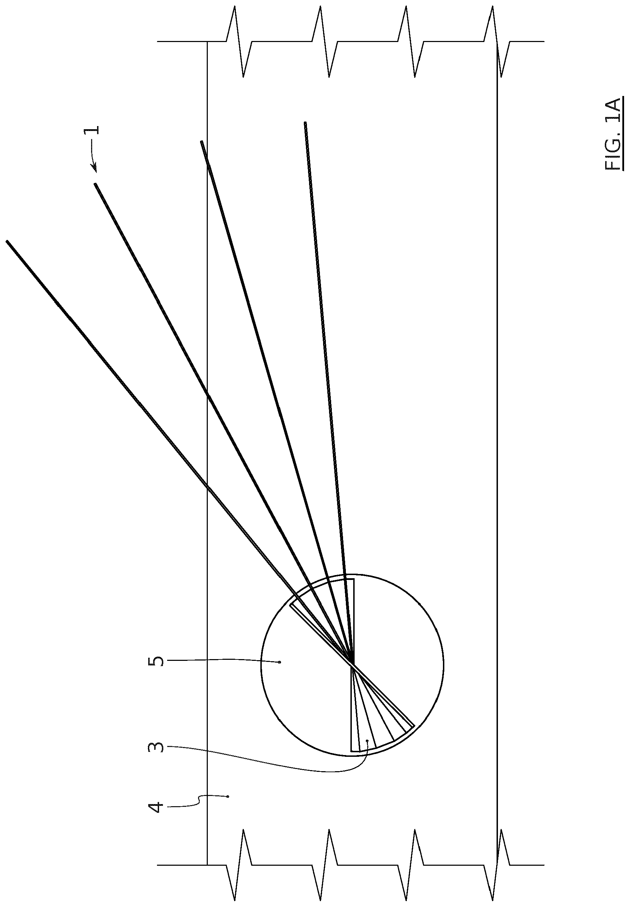

En référence à la figure 1, un aspect de l'invention consiste à proposer un nouveau système d'intégration 10 de composants photovoltaïques à un bâtiment, de préférence à une façade de bâtiment. La solution d'intégration proposée met en œuvre :
a. au moins un module photovoltaïque 1, de préférence une pluralité de modules photovoltaïques, et
b. au moins une structure porteuse 4.

Comme nous le détaillerons plus loin, chaque module photovoltaïque 1 présente un design nouveau, adapté au système d'intégration 10 proposé. Chaque module photovoltaïque 1 est plus particulièrement conçu pour être supporté par, ou monté sur, une structure porteuse 4 elle-même conçue pour y monter le module photovoltaïque 1.

Chaque module photovoltaïque 1 comprend, comme à l'ordinaire, une pluralité de cellules photovoltaïques 12 encapsulées dans un substrat 11.

Le substrat de chaque module photovoltaïque 1 peut être obtenu par lamination d'une pluralité de couches à base de matériaux choisis pour leurs propriétés de transparence et/ou leurs propriétés de maintien mécanique et/ou leurs propriétés de protection des cellules photovoltaïques 12. C'est sur des substrats 11 de cette nature, et de géométrie souvent rectangulaire, que l'on vient usuellement reporter une face avant et/ou une face arrière, et éventuellement un cadre, pour conférer, au module photovoltaïque 1, une rigidité et une protection adaptée à son usage et/ou son intégration.

Le substrat 11 encapsule donc les cellules photovoltaïques 12. On peut ainsi parler, de façon équivalente, de « substrat encapsulant », ou même simplement d'« encapsulant », comme cela est généralement le cas dans le domaine des modules photovoltaïques.

Ici, c'est par le substrat 11, et de préférence directement par ce substrat, que le module photovoltaïque 1 sera monté sur la structure porteuse 4.

Ainsi, le module photovoltaïque 1 selon le premier aspect de l'invention est de préférence exempt de l'un au moins parmi : un cadre, une face avant et une face arrière, tels que mentionnés ci-dessus.

En alternative, il est envisageable que le module photovoltaïque 1 comprenne au moins l'une parmi une face avant et une face arrière, cette dernière étant alors constituée par exemple de polycarbonate ou d'un matériau pré-imprégné. Une telle face avant et/ou arrière permettrait d'augmenter la rigidité du module photovoltaïque 1, et plus spécifiquement des sous-modules photovoltaïques qui le composent et dont nous discutons par la suite, à l'exclusion du reste du module photovoltaïque 1.

Les cellules photovoltaïques 12 peuvent être des cellules organiques. Elles peuvent être à base de silicium ou à base de couche mince, par exemple de CIGS, mais peuvent être issues de n'importe quelle technologie *ad hoc.* Elles peuvent intégrer un film dont les propriétés sont de donner une couleur à la cellule.

Comme nous le verrons plus loin, chaque cellule peut être vue comme un pixel d'une image formée par une pluralité de modules photovoltaïques 1 compris dans le système d'intégration 10. À ce titre, l'on comprend qu'il puisse être avantageux que ces cellules présentent différentes couleurs et/ou prennent la forme de demi-cellules. Il est en outre possible de découper les cellules photovoltaïques 12, de sorte d'obtenir des cellules de tailles inférieures, et présentant éventuellement différentes formes. En effet, l'image alors générée peut être enrichie et de qualité améliorée.

Les propriétés mécaniques du substrat 11, et en particulier les propriétés de tenue mécanique et les propriétés de déformation mécanique du substrat, combinées à ses propriétés géométriques, sont de première importance lorsqu'il s'agit de concevoir un module photovoltaïque 1 selon l'aspect principal de l'invention.

En ce sens, notons que la tenue mécanique du substrat 11 doit être suffisante pour que le module photovoltaïque ne se déforme pas sans sollicitation extérieure, et par exemple sous le poids des cellules photovoltaïques 12, et ce quel que soit, ou plus généralement de façon adaptée à, sa géométrie.

Notons également que le module photovoltaïque peut avantageusement être conçu de sorte que ses propriétés de déformation mécanique notamment ne soient pas les mêmes sur toute son étendue, mais au contraire varient sur son étendue. Comme nous le verrons plus bas de façon détaillée, des variations locales des propriétés mécaniques du substrat 11 peuvent être obtenues par une variation de la constitution du substrat 11 sur son étendue et/ou par une variation locale de sa géométrie.

Un substrat conforme aux exigences indiquées ci-dessus peut comprendre, ou être constitué de, matériaux usuellement utilisés pour former les modules photovoltaïques connus de l'art antérieur. Parmi ces matériaux, un composite d'un polymère et d'un matériau de renfort sera préféré dans le cadre de la présente invention. Plus particulièrement, un matériau de renfort comprenant, ou étant constitué de, un tissu à base de polypropylène avec un taux de fibres de verre de 60 % en masse sera préféré.

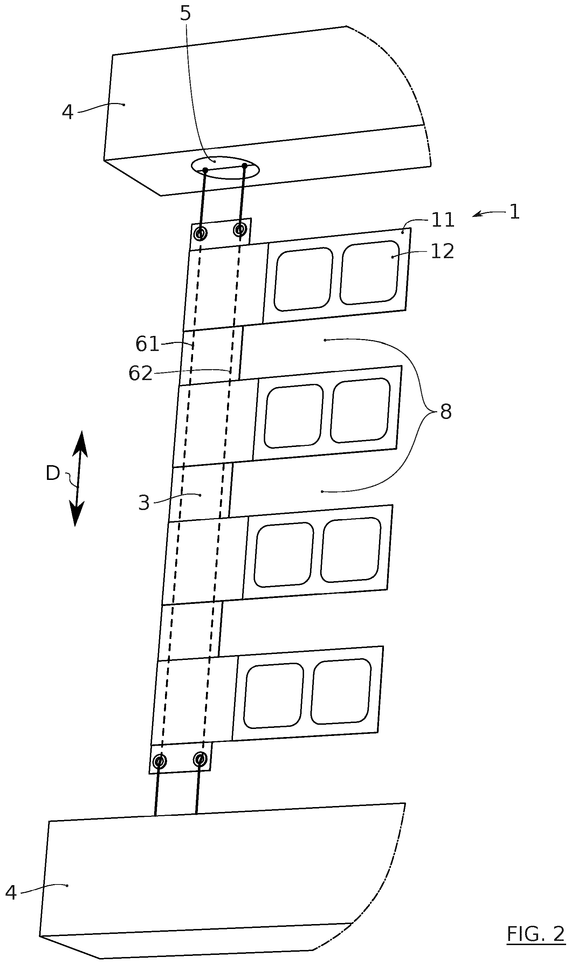

Chaque structure porteuse 4 est destinée à être fixée sur le bâtiment de préférence sur sa façade. Elle peut adopter une configuration simple comportant deux poutres comme illustré sur les figures 1 et 2, ou adopter toute autre configuration compatible avec sa fonction de maintien du ou des modules photovoltaïques 1.

Ainsi, la conception des modules photovoltaïques 1 et la conception de la structure porteuse 4 associée à ces modules photovoltaïques 1 sont liées entre elles. Par exemple, il est envisageable que les deux poutres constituant la structure porteuse 4 telle qu'illustrée sur la figure 1 ne soient pas fixées sur le bâtiment parallèlement entre elles, mais soient fixées de sorte à former entre elles un angle que les modules 1 permettraient d'accommoder en présentant par exemple différentes longueurs.

La structure porteuse 4 peut le cas échéant avoir en outre une fonction d'actuateur du ou des modules 1 qu'elle supporte. Chaque module 1 peut en effet être monté de façon fixe ou mobile sur la structure porteuse 4.

Si le module 1 est monté de façon mobile sur la structure porteuse, cette dernière peut comporter un actuateur configuré de sorte que le module puisse être déplacé en translation et/ou en rotation par rapport à la structure porteuse 4.

Que les modules photovoltaïques 1 soient mobiles sur la structure porteuse 4 permet de les déplacer pour favoriser notamment l'une au moins parmi : la maximisation de la production électrique, la maximisation du confort thermique dans le bâtiment, la maximisation de l'espace à l'arrière des modules, la protection contre l'éblouissement par l'ensoleillement direct, la détermination d'une configuration globale répondant à une esthétique particulière à l'échelle de la façade du bâtiment.

Chaque module 1 est conçu pour avoir un poids, et plus particulièrement une répartition de poids, compatible d'une part avec la capacité de maintien ou de portance de l'organe de liaison 3, d'autre part avec une architecture générale du champ de composants photovoltaïques qu'il compose pour former le système d'intégration 10. Plus particulièrement, l'organe de liaison 3 peut être vu comme formant un mât dont au moins une des deux extrémités 31, 32 est destinée à être fixée sur la structure porteuse 4, et depuis lequel s'étendent transversalement des sous-modules photovoltaïques 2A, 2B, selon diverses répartitions, symétriques ou non.

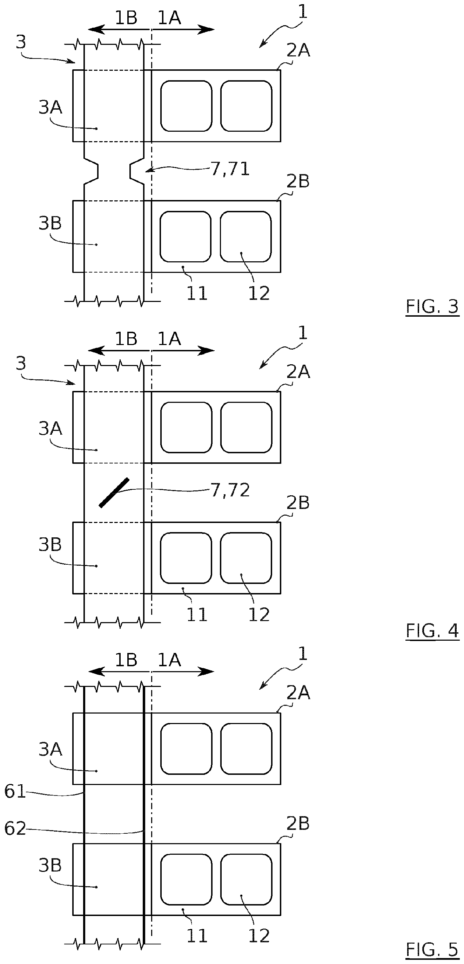

En référence aux figures 3 à 5, un module photovoltaïque 1 selon le premier aspect de l'invention est décrit ci-après. Chaque module photovoltaïque 1 illustré sur ces figures présente une structure souple s'étendant depuis, ou dépassant de, une pluralité de sous-modules photovoltaïques 2A, 2B, etc. Cette structure souple, au moins en partie formée par le substrat 11, peut être définie comme un organe liant entre eux les sous-modules photovoltaïques 2A, 2B. En tant que telle, la structure souple présente donc une fonction d'organe de liaison 3 entre les sous-modules photovoltaïques 2A, 2B. Il est ainsi permis de fixer chaque sous-module 2A, 2B à la structure porteuse 4 par l'intermédiaire de l'organe de liaison 3, sans avoir nécessairement recours à un cadre métallique.

Plus particulièrement, chaque module photovoltaïque 1 présente une première partie 1A comprenant les cellules photovoltaïques 12 réparties en sous-modules photovoltaïques 2A, 2B disjoints entre eux et une deuxième partie 1B exempte de cellules photovoltaïques et s'étendant depuis la première partie 1A pour former l'organe de liaison 3 joignant entre eux les sous-modules photovoltaïques 2A, 2B, etc. Plus particulièrement, les sous-modules photovoltaïques sont disjoints entre eux par des espaces 8 vides ménagés entre sous-modules photovoltaïques adjacents. Nous verrons plus loin que de tels espaces 8 peuvent correspondre à des parties à découper dans un produit intermédiaire obtenu par l'étape de lamination.

L'organe de liaison 3 peut plus particulièrement être configuré pour présenter une souplesse telle qu'une déformation de l'organe de liaison induise un mouvement d'au moins l'un, de préférence de plusieurs, potentiellement de chacun, des sous-modules photovoltaïques 2A, 2B, etc. La déformation de l'organe de liaison 3 n'induit de préférence aucune déformation des sous-modules photovoltaïques 2A, 2B, etc. Le mouvement du ou des sous-modules photovoltaïques est fonction, voire directement fonction, de la déformation de l'organe de liaison 3.

Une certaine souplesse de l'organe de liaison 3 est particulièrement requise dans le cas où le module photovoltaïque 1 est destiné à être déformé par torsion du fait de la rotation sur elle-même d'au moins une de ses extrémités 31, 32. Cette souplesse de l'organe de liaison 3 s'apprécie en particulier relativement à la souplesse, ou plutôt à la rigidité, des sous-modules photovoltaïques 2A, 2B. Plus particulièrement, il est avantageux que l'organe de liaison 3 soit configuré pour présenter, au moins localement, une plus grande souplesse que les sous-modules photovoltaïques 2A, 2B. De la sorte, une déformation de l'organe de liaison 3 induit un mouvement de chacun des sous-modules photovoltaïques 2A, 2B, ces derniers restants de préférence indéformés malgré la déformation de l'organe de liaison 3.

L'organe de liaison 3 peut être utilisé pour monter ou suspendre le module 1 auquel il appartient sur la structure porteuse 4, par exemple des façons illustrées sur les figures 1 et 2.

Sur la figure 1, le module photovoltaïque 1 est plus particulièrement monté directement à la structure porteuse 4 par les extrémités 31, 32 de l'organe de liaison 3.

Sur la figure 2, le module photovoltaïque 1 est monté à la structure porteuse 4 par l'intermédiaire d'au moins deux câbles 61, 62 s'étendant au-delà des extrémités 31, 32 de l'organe de liaison 3 pour être montés sur la structure porteuse.

L'organe de liaison 3 peut en outre supporter des pistes électriques (non représentées) connectant entre elles les cellules photovoltaïques 12 d'au moins un sous-module 2A, 2B, etc., de certains sous-modules, voire de tous les sous-modules d'un même module photovoltaïque 1. Ces pistes peuvent être disposées en surface de l'organe de liaison 3, mais sont de préférence intégrées à l'intérieur de cet organe entre une surface avant et une surface arrière de celui-ci. Les pistes électriques ou métalliques pourront relier les sous-modules 2A, 2B entre eux, et plus particulièrement les cellules photovoltaïques 12 entre elles, selon un branchement en série ou en parallèle. Les pistes électriques peuvent se croiser sans se toucher en disposant par exemple une pièce d'un matériau isolant entre les pistes avant de procéder à l'étape de lamination du procédé de fabrication d'un module photovoltaïque 1 sur lequel nous reviendrons plus bas.

Une guirlande ou une grappe de sous-modules photovoltaïques 2A, 2B connectés peut ainsi être obtenue. L'organe de liaison 3 permet ainsi de connecter électriquement les sous-modules 2A, 2B, etc. sans avoir nécessairement recours à un connecteur. Selon un mode de réalisation préférée de l'invention, le module photovoltaïque 1 est exempt d'un connecteur.

L'association mécanique et électrique de plusieurs sous-modules entre eux est ainsi rendue possible par l'organe de liaison 3. Lorsqu'une même structure porteuse 4 supporte, comme illustré sur la figure 1, une pluralité de modules photovoltaïques 1 selon le premier aspect de l'invention, un champ complet de composants photovoltaïques intégrés au bâtiment peut être réalisé, par exemple pour obtenir une façade de bâtiment pixélisée. Chacun des sous-modules 2A, 2B peut montrer un comportement différent du ou des sous-modules adjacents en réponse à une déformation, notamment en torsion, de l'organe de liaison 3.

La figure 1 illustre particulièrement cela. Sur cette figure, l'organe de liaison 3 s'étend selon une direction principale D déterminée et sa déformation est induite par sa torsion avec un moment de force agissant dans ladite direction principale D.

Pour autant, d'autres types de déformation sont également envisageables, tels qu'une flexion, combinés ou non à une déformation par torsion. Sur la figure 1, alors que l'organe de liaison 3 du module photovoltaïque 1 de gauche n'est pas déformé, les sous-modules photovoltaïques sont sensiblement alignés dans un plan défini par le substrat 11 du module photovoltaïque, tandis que, pour chacun des trois autres modules représentés, l'organe de liaison 3 est déformé, ici par torsion induite par un actuateur 5 intégré dans la poutre supérieure de la structure porteuse 4. Les sous-modules photovoltaïques proches de l'actuateur 5 sont davantage déplacés que les modules photovoltaïques plus éloignés de l'actuateur 5. Ces derniers peuvent d'ailleurs ne pas être déplacés du tout. Observons également que sur ces trois autres modules 1 représentés, celui du centre présente un organe de liaison 3 davantage déformé que les deux autres ; le déplacement des sous-modules proches de l'actuateur 5 est alors d'une amplitude plus importante ; pour autant, le sous-module le plus éloigné de l'actuateur 5 n'est pas nécessairement déplacé.

Ces considérations sont également illustrées par la figure 1B. Cette figure représente une vue schématique du dessus d'une partie du système d'intégration 10. On n'y voit qu'une déformation en torsion de l'organe de liaison 3 par l'actuateur 5 lui fait prendre une forme hélicoïdale et induit l'occupation par chaque sous-module du module photovoltaïque 1 d'un secteur angulaire qui lui est propre.

De préférence, lorsque l'organe de liaison est ramené dans sa configuration non déformée, dite aussi configuration neutre, l'organe de liaison et les sous-modules se retrouvent à nouveau sensiblement dans un même plan.

Il est préféré que le système d'intégration 10 soit configuré pour permette des déformations successives de l'organe de liaison 3 de sorte à induire des déplacements des sous-modules 2A, 2B d'une façon reproductible.

Ce comportement des sous-modules 2A, 2B est lié à la souplesse de la deuxième partie 1B du module photovoltaïque 1, de l'organe de liaison 3, et des protrusions 3A, 3B, équivalemment, relativement à la rigidité des sous-modules 2A, 2B. Comme annoncé plus haut, cette souplesse peut être contrôlée localement, notamment en contrôlant les caractéristiques géométriques locales et/ou les caractéristiques mécaniques locales de la deuxième partie 1B du module photovoltaïque 1. Ce contrôle est notamment rendu possible par le biais d'au moins un élément de contrôle 7 de la souplesse, ou équivalemment de la rigidité, locale de la deuxième partie 1B.

Les figures 3 et 4 illustrent différentes façons de contrôler localement la souplesse de la deuxième partie 1B du module photovoltaïque 1.

Une première solution illustrée sur la figure 3 consiste à réaliser au moins un retrait de matière 71 dans l'organe de liaison 3. Les retraits de matière 71 tels qu'illustrés sur la figure 3 sont répartis de façon symétrique par rapport à l'axe longitudinal de l'organe de liaison 3 et sont réalisés entre deux jonctions à un sous-module photovoltaïque 2A, 2B. Cependant, il n'est pas nécessaire que les retraits de matière soient réalisés de façon symétrique, ni même qu'ils soient localisés entre deux jonctions à un sous-module photovoltaïque. Par exemple, un retrait de matière pourrait être réalisé dans la protrusion 3A, 3B s'étendant depuis un sous-module photovoltaïque 2A, 2B, et plus particulièrement dans une portion de la deuxième partie 1B du module photovoltaïque située au plus proche de la première partie 1A dudit module, pour assouplir localement la liaison mécanique entre l'organe de liaison 3 et le sous-module 2A, 2B concerné. Ainsi, pour contrôler localement la souplesse du module photovoltaïque 1, et de la guirlande qu'il constitue, et ainsi permettre notamment une plus grande amplitude de rotation des sous-modules 2A, 2B, il est possible de pratiquer des découpes 71 dans l'organe de liaison 3, en s'assurant toutefois de conserver une surface de substrat 11 au niveau de l'organe de liaison 3 nécessaire et suffisante à la connexion mécanique et électrique qu'assure l'organe de liaison 3.

Une autre solution de contrôle de la souplesse de la deuxième partie 1B du module photovoltaïque est illustrée sur la figure 4. Elle consiste à disposer un insert 72, tel qu'un film, un patch ou une barre, par exemple en aluminium de sorte à augmenter localement la rigidité de l'organe de liaison 3. La disposition de l'insert 72 peut être réalisée par report de l'insert sur l'organe de liaison 3, ou peut être réalisé par lamination conjointe de l'insert avec différentes couches de matériaux pour former l'organe de liaison 3. Selon cette dernière variante, l'insert 72 rigide peut être laminé dans la deuxième partie 1B du module photovoltaïque 1, et ce de préférence au cours de la même étape de lamination que celle qui permet la fabrication du module photovoltaïque 1 selon le premier aspect de l'invention. L'insert 72 peut présenter une épaisseur comprise entre 0,1 et 1 mm, plus particulièrement entre 0,2 et 0,5 mm. L'insert 72 est par exemple une barre, un patch ou un film, à base d'aluminium et d'épaisseur comprise entre 0,2 et 1 mm, ou à base d'acier inoxydable et d'épaisseur comprise entre 0,1 et 0,5 mm. L'insert 72 tel qu'illustré sur la figure 4 est disposé entre deux jonctions à un sous-module photovoltaïque 2A, 2B, mais pourrait être disposé en tout autre endroit *ad hoc* de l'organe de liaison 3.

Il est à noter ici que les deux solutions ci-dessus énoncées de contrôle de la souplesse de la deuxième partie 1B du module photovoltaïque 1 peuvent être combinées entre elles selon une variété de configurations très large.

Ainsi, si le premier paramètre à considérer en ce qui concerne la souplesse de la deuxième partie 1B du module photovoltaïque 1 relativement à la souplesse de la première partie 1A reste la géométrie, de préférence sensiblement plane, et la composition de l'organe de liaison 3 et leurs éventuelles variations locales, des éléments de contrôle 7 tels que décrits ci-dessus permettent d'atteindre un contrôle plus fin, voire une modularité par segment, par exemple par paires ou par triplettes de sous modules adjacents entre eux, de la souplesse de la deuxième partie 1B du module photovoltaïque 1.

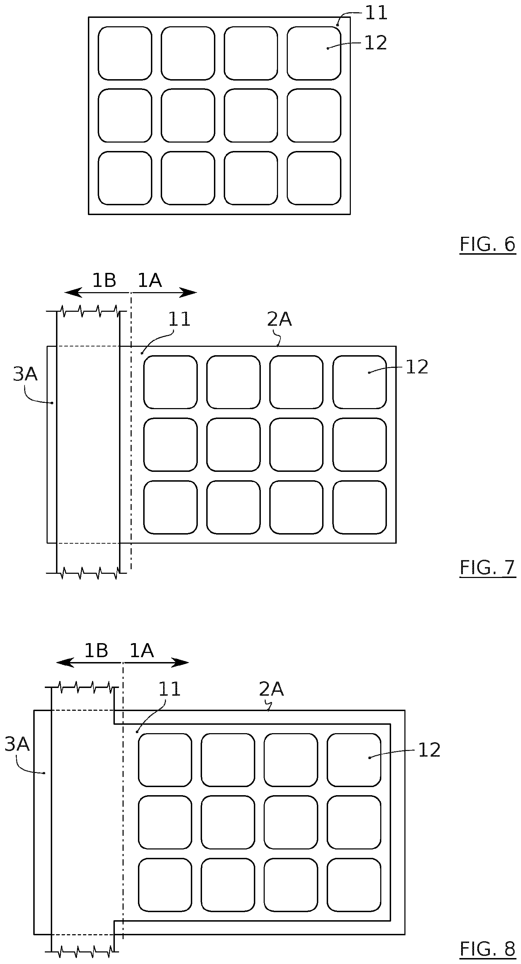

En référence aux figures 6 à 9, plusieurs modes de réalisation de l'organe de liaison 3, et plus généralement de la deuxième partie 1B du module photovoltaïque 1, sont décrits ci-dessous.

Notons tout d'abord que la figure 6 illustre schématiquement une vue de face d'un module photovoltaïque selon l'art antérieur, comportant douze cellules photovoltaïques 12 encapsulées dans un substrat 11, pour former une surface de captation de l'énergie solaire sensiblement rectangulaire et plane. En effet, il n'est généralement pas utile, ou rechercher, qu'un module photovoltaïque présente une protrusion par laquelle son substrat 11 s'étendrait, surtout si cette protrusion n'a, comme c'est le cas dans la présente invention, aucune fonction de captation de l'énergie solaire. En dehors du contexte de la présente invention, une telle protrusion correspondrait à une perte de surface de captation et/ou un surcoût de matière et de fabrication.

Dans le cadre de la présente invention, de telles protrusions 3A, 3B, formant tout ou partie de l'organe de liaison 3 peuvent avantageusement être prévues pour lier entre eux les sous-modules photovoltaïques 2A, 2B, ces derniers pouvant par ailleurs chacun être en tout point conforme à un module photovoltaïque selon l'art antérieur, par exemple un module photovoltaïque tel qu'illustré sur la figure 6. C'est ce qu'illustre une comparaison de la figure 6 avec l'une quelconque des figures 7 à 9.

Sur la figure 7, un premier mode de réalisation de l'organe de liaison 3 est illustré selon lequel la protrusion 3A s'étendant depuis le sous-module 2A vient recouvrir ou être recouverte d'une bande (ou un mât) s'étendant de sorte à joindre entre elles les protrusions des sous-modules d'un même module photovoltaïque 1. Cette vision est davantage spirituelle que structurelle, puisque, comme mentionné plus haut et comme décrit en détails plus bas, le module photovoltaïque 1 est de préférence obtenue en une seule et unique étape de lamination, de sorte qu'il apparaît *in fine* comme une seule et même pièce, et non comme des pièces conçues séparément, puis jointes entre elles.

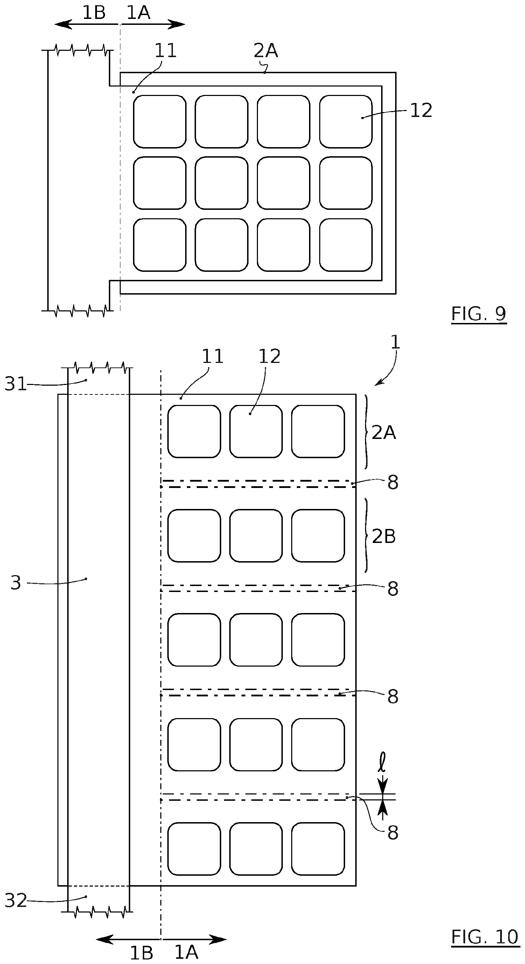

Il en va de même des modes de réalisation du module photovoltaïque 1 illustrés sur les figures 8 et 9 qui diffèrent respectivement du mode de réalisation illustré sur la figure 7 par :
a. le fait que la bande joignant entre elles les protrusions 3A, 3B des sous-modules 2A, 2B peut s'étendre sur tout ou partie de la surface des sous-modules, en étant disposée soit en dessous, soit au-dessus, soit entre, les couches destinées à constituer après lamination la partie du substrat 11 encapsulant les cellules photovoltaïques 12 (Cf. figure 8), et
b. le fait que le sous-module 2A peut ne pas s'étendre par une protrusion, la bande joignant directement entre eux les sous-modules 2A, 2B s'étendant alors sur tout ou partie de la surface des sous-modules, en étant disposée soit en dessous, soit au-dessus, soit entre, les couches destinées à constituer après lamination la partie du substrat 11 encapsulant les cellules photovoltaïques 12 (Cf. figure 9).

Le module photovoltaïque 1 selon le premier aspect de l'invention est avantageux par sa simplicité de conception, mais également de par sa simplicité de fabrication qui révèle son faible coût.

En effet, l'invention concerne, selon un autre de ses aspects, un procédé de fabrication du module photovoltaïque 1 selon le premier aspect de l'invention.

Ce procédé est essentiellement tel qu'il comprend une unique étape de lamination pour former le substrat 11 en y encapsulant les cellules photovoltaïques 12 et pour former au moins lesdites premières et deuxièmes parties 1A ,1B du module photovoltaïque 1. Cette unique étape de lamination est donc réalisée sur un empilement de plusieurs couches de matériaux dont font parties les cellules photovoltaïques 12 et au moins un matériau propre à constituer un encapsulant les cellules photovoltaïques 12. L'empilement à laminer peut ou non être symétrique dans son épaisseur et/ou dans son étendue.

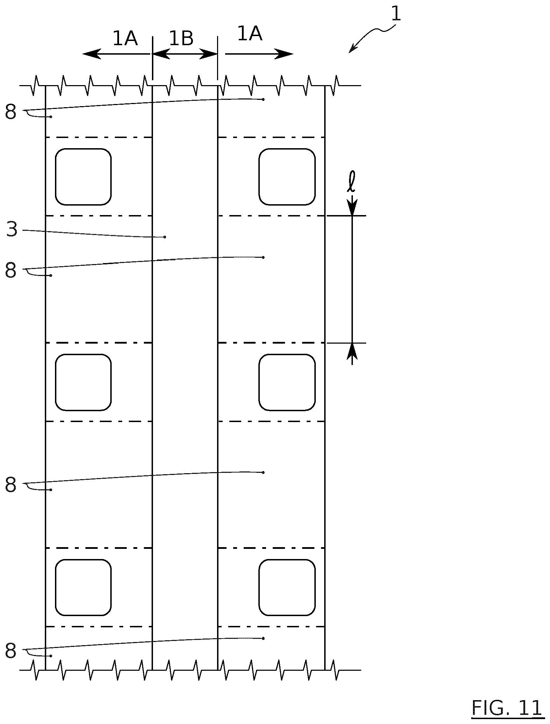

Pour des raisons de simplicité du procédé de fabrication, et donc de réduction du coût de fabrication, il est particulièrement avantageux que l'empilement à laminer soit globalement d'une forme simple, typiquement d'une forme rectangulaire. L'étape de lamination peut alors conduire à la fabrication d'un produit intermédiaire tel qu'illustré sur les figures 10 et 11. Partant de ce produit intermédiaire, il suffit que le procédé de fabrication comprenne en outre une étape de découpage d'au moins une partie 8 du substrat situé entre chaque paire de sous-modules photovoltaïques 2A, 2B, pour obtenir le module photovoltaïque 1 selon le premier aspect de l'invention.

Le module photovoltaïque 1, comprenant potentiellement plus de deux sous-modules photovoltaïques, une pluralité de parties 8 peuvent devoir être découpées.

En comparant les figures 10 et 11 entre elles, il apparaît deux types de modules photovoltaïques 1, celui illustré sur la figure 10 où la largeur *l* de la découpe est relativement faible par rapport à l'étendue des sous-modules photovoltaïques selon la direction principale d'extension D de l'organe de liaison 3 et celui illustré sur la figure 11 où la largeur *l* de la découpe est strictement plus grande que l'étendue des sous-modules la direction principale d'extension D de l'organe de liaison 3. Il apparaît également que les sous-modules 2A, 2B peuvent s'étendre d'un même côté de l'organe de liaison 3 ou des deux côtés de l'organe de liaison 3.

Lorsque les sous-modules 2A, 2B s'étendent d'un même côté de l'organe de liaison 3, un avantage apparaît en ce que la déformation par torsion de l'organe de liaison 3 peut être paramétrée de sorte à conduire uniquement à un éloignement des sous-modules 2A, 2B depuis la façade du bâtiment.

Au contraire, lorsque les sous-modules 2A, 2B s'étendent des deux côtés de l'organe de liaison 3, la déformation par torsion de l'organe de liaison 3 conduit incontournablement à un déplacement d'un des sous-modules vers la façade du bâtiment.

Ainsi, pour des raisons de minimisation de l'espacement entre les modules photovoltaïques 1 et la façade du bâtiment, il peut être préféré que les sous-modules 2A, 2B s'étendent d'un même côté de l'organe de liaison 3. En effet, cette minimisation peut être un élément déterminant pour l'esthétique globale du système d'intégration selon l'invention.

Notons que sur la figure 10 sont représentés les extrémités 31, 32 de l'organe de liaison 3. Bien que cela ne soit pas illustré ici, il est tout à fait envisageable que ces extrémités aient été obtenues par découpe du pourtour du produit intermédiaire issu de l'étape de lamination. Ce mode de fabrication augmente certes les chutes produites par l'étape de découpage, mais permet de conserver une forme simple des plateaux de lamination et de l'empilement à laminer. En alternative, il est également envisageable de juxtaposer différentes paires de plateaux de lamination entre eux pour obtenir une forme plus complexe (que la forme simplement rectangulaire), et notamment une forme convexe, voire le cas échéant la forme finale du module photovoltaïque 1 selon le premier aspect de l'invention.

Au vu de la figure 10, l'on comprend que la découpe correspondante des parties 8 du substrat 11 conduit à des modules photovoltaïques 1 tels qu'illustrés notamment sur les figures 1 et 2, où les sous-modules 2A, 2B d'un même module photovoltaïque 1 occupent globalement une même zone colonnaire.

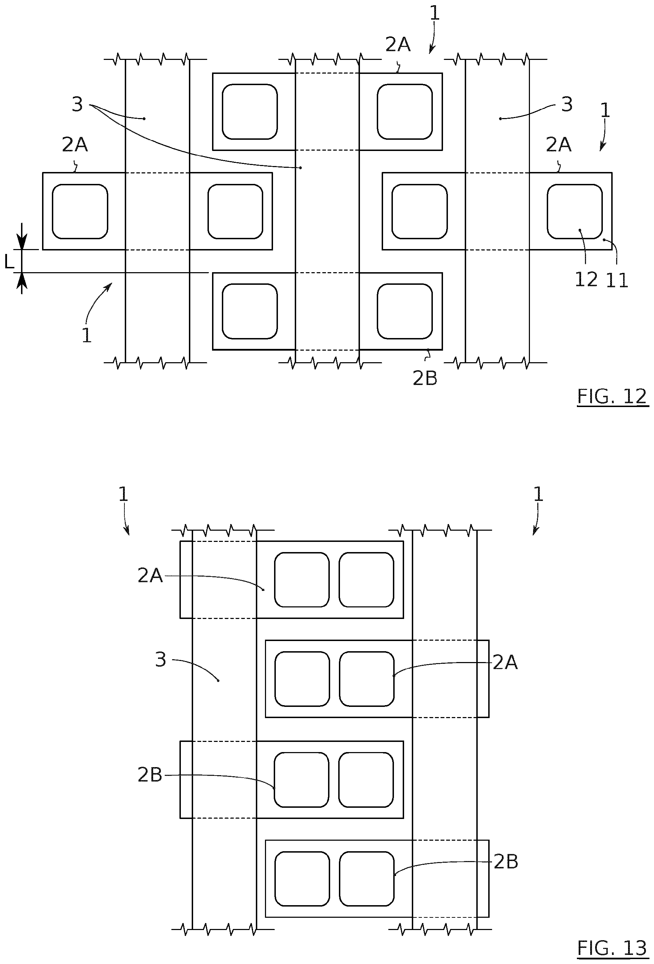

Au vu de la figure 11, on comprend que la découpe correspondante des parties 8 du substrat 11 conduit à des modules photovoltaïques 1 propres à être agencés entre eux de façon interdigitée, par exemple selon l'une ou l'autre des configurations illustrées sur les figures 12 et 13.

Il apparaît ainsi que le procédé de fabrication selon le deuxième aspect de l'invention, simple et viable industriellement, permet l'obtention d'une certaine variété de modules photovoltaïques 1 et d'une variété correspondante d'agencements relatifs des modules photovoltaïques 1 sur la structure porteuse 4, pour atteindre avantageusement une grande modularité d'intégration du système 10 offrant autant d'opportunités aux concepteurs de façade de bâtiment de se distinguer à la fois par des caractéristiques techniques spécifiques de chaque système 10, tels que la surface de captation d'énergie solaire, la capacité à ombrager l'intérieur du bâtiment, et par des caractéristiques esthétiques, tels que le nombre de cellules par sous-module, la couleur et la taille des cellules, leur interdigitation.

Notons que, en cas de grand vent, la relative souplesse de l'organe de liaison 3 de chaque module photovoltaïque 1 peut conduire à des mouvements indésirés, voire à l'endommagement, du module photovoltaïque 1. Pour pallier cette éventualité, il est envisagé que le système d'intégration 10 comprenne un système de verrouillage 9 du mouvement des extrémités libres des sous-modules 2A, 2B entre elles et relativement à la structure porteuse 4. Plus particulièrement, un câble tel qu'illustré sur la figure 1 peut lier entre elles des extrémités libres 21 des sous-modules 2A, 2B et la structure porteuse 4 de façon lâche lorsque les vents sont faibles, puis de façon tendue lorsque les vents sont forts, de sorte à ramener le système d'intégration 10 selon l'invention dans une configuration neutre de ses organes de liaison, et contribuer ainsi à préserver son intégrité. Un simple enrouleur à câble commandé par exemple sous le contrôle d'un anémomètre adéquatement placé sur la surface du bâtiment peut suffire à mettre en œuvre cette fonction.

Par ailleurs, notons que la déformation de l'organe de liaison 3, notamment par torsion, est susceptible de créer des contraintes, notamment d'étirement, dans l'organe, en particulier lorsque les extrémités 31, 32 de l'organe sont fixées à la structure porteuse 4. Afin de gérer ces contraintes, il est proposé que le système d'intégration 10 comprenne en outre un mécanisme de compensation (non représenté sur les figures) de l'étirement subi par l'organe de liaison 3 lors de sa déformation, notamment par torsion. Un tel mécanisme peut par exemple mettre en oeuvre un ou plusieurs ressorts, ou tout autre organe de rappel apte à accommoder la déformation de l'organe de liaison au niveau de ses extrémités pour relâcher les contraintes produites par sa déformation. L'on éloigne ainsi tout risque de déchirement de l'organe de liaison du fait de sa déformation.

L'invention n'est pas limitée aux modes de réalisations précédemment décrits et s'étend à tous les modes de réalisation couverts par les revendications.

Notamment, il existe des modules photovoltaïques bifaciaux, c'est-à-dire des modules capables de capter le rayonnement solaire qu'il soit incident sur leur face avant ou sur leur face arrière. Il n'est évidemment pas exclu que le module photovoltaïque 1 selon le premier aspect de l'invention comprenne des sous-modules présentant cette caractéristique, de sorte que puissent être captées non seulement le rayonnement solaire frappant directement le bâtiment, mais également le rayonnement solaire réfléchi par la façade du bâtiment sur laquelle le système 10 est intégré.

Par ailleurs, le système 10 n'est pas limité à une intégration au bâtiment ou en façade d'un bâtiment. En effet, toutes sortes d'infrastructures support peut être avantageusement équipées du système d'intégration 10 selon l'invention. Parmi ces infrastructures support, on peut citer des éléments de mobilier urbain, ainsi que des véhicules.

## Revendications

1. Module photovoltaïque (1) comprenant :
- un substrat (11), et
- une pluralité de cellules photovoltaïques (12) encapsulées dans le substrat (11),
le module présentant :
- une première partie (1A) comprenant les cellules photovoltaïques (12) réparties en au moins deux sous-modules photovoltaïques (2A, 2B, etc.) disjoints entre eux, et
- une deuxième partie (1B) exempte de cellules photovoltaïques et s'étendant depuis la première partie (1A) du module pour former un organe de liaison (3) joignant entre eux les sous-modules photovoltaïques (2A, 2B, etc.),
l'organe de liaison (3), au moins en partie formé par le substrat (11), étant configuré pour être monté sur une structure porteuse (4) et pour présenter une souplesse telle qu'une déformation de l'organe de liaison (3) induise un mouvement d'au moins l'un, de préférence de plusieurs, potentiellement de chacun, des sous-modules photovoltaïques (2A, 2B, etc.), sans déformation des sous-modules photovoltaïques (2A, 2B, etc.), ledit mouvement étant fonction de la déformation de l'organe de liaison (3),
le module (1) étant **caractérisé en ce que**, l'organe de liaison (3) s'étendant selon une direction principale D déterminée, la déformation de l'organe de liaison comprend une torsion de l'organe de liaison avec un moment de force agissant dans ladite direction principale D.

2. Module photovoltaïque (1) selon la revendication précédente, dans lequel l'organe de liaison (3) comprend au moins une pluralité de protrusions (3A, 3B, etc.) s'étendant chacune depuis un sous-module photovoltaïque (2A, 2B, etc.) et une partie formant un mât dont au moins une des deux extrémités (31, 32) est configurée pour être montée sur la structure porteuse (4), chaque protrusion s'étendant le cas échéant jusqu'à joindre le mât.

3. Module photovoltaïque (1) selon l'une quelconque des revendications précédentes, dans lequel, pour une même déformation de l'organe de liaison (3), le mouvement d'au moins un sous-module (2A, 2B, etc.), voire de chaque sous-module, est différent, mais dépendant, d'un mouvement d'un autre sous-module (2A, 2B, etc.), voire de chaque autre sous-module.

4. Module photovoltaïque (1) selon l'une quelconque des revendications précédentes, configuré de sorte qu'une déformation en torsion de l'organe de liaison (3) autour de sa direction principale d'extension D entraîne une rotation des sous-modules photovoltaïques (2A, 2B, etc.) autour de cette direction.

5. Module photovoltaïque (1) selon l'une quelconque des revendications précédentes, dans lequel l'organe de liaison (3) forme au moins un mât dont au moins une des deux extrémités (31, 32) est destinée à être montée sur la structure porteuse (4).

6. Module photovoltaïque (1) selon l'une quelconque des revendications précédentes, dans lequel l'organe de liaison (3) a une fonction de liaison mécanique des sous-modules (2A, 2B, etc.) entre eux et une fonction de liaison électrique des cellules photovoltaïques (12) entre elles et/ou des sous-modules (2A, 2B, etc.) entre eux.

7. Module photovoltaïque (1) selon l'une quelconque des revendications précédentes, comprenant en outre des pistes conductrices d'électricité encapsulées dans le substrat (11) et s'étendant entre les première et deuxième parties (1A, 1B) du module pour relier entre elles les cellules photovoltaïques (12), en série ou en parallèle, et permettre la connexion du module (1) à au moins une connectique extérieure au module telle qu'une boîte de jonction.

8. Module photovoltaïque (1) selon l'une quelconque des revendications précédentes, dans lequel la première partie (1A) du module s'étend d'un unique côté de la deuxième partie (1B) du module.

9. Module photovoltaïque (1) selon l'une quelconque des revendications précédentes, comprenant en outre au moins deux câbles de renfort (61, 62) sensiblement parallèles entre eux et s'étendant sur toute une longueur de l'organe de liaison (3), voire au-delà.

10. Module photovoltaïque (1) selon l'une quelconque des revendications précédentes, dans lequel l'organe de liaison (3) comprend en outre au moins un élément de contrôle (7) de rigidité locale choisi parmi :
a. Un retrait de matière (71) pour diminuer localement la rigidité de l'organe de liaison,
b. un insert (72), tel qu'un film, un patch ou une barre, pour augmenter localement la rigidité de l'organe de liaison.

11. Procédé de fabrication d'un module photovoltaïque (1) selon l'une quelconque des revendications 1 à 10, **caractérisé en ce qu'**il comprend une unique étape de lamination configurée pour encapsuler les cellules photovoltaïques (12) dans le substrat (11) et pour former au moins lesdites première et deuxième parties (1A, 1B) du module photovoltaïque (1).

12. Système d'intégration (10) de composants photovoltaïques à un bâtiment, de préférence à une façade de bâtiment, comprenant une pluralité de modules photovoltaïques (1) selon l'une quelconque des revendications 1 à 10, et une structure porteuse (4) destinée à être fixée sur le bâtiment, de préférence sur la façade de bâtiment.

13. Système d'intégration (10) selon la revendication précédente, dans lequel l'organe de liaison (3) d'au moins un module (1), de préférence de chaque module, forme un mât dont au moins une des deux extrémités (31, 32) est montée sur la structure porteuse (4).

14. Système d'intégration (10) selon la revendication précédente, dans lequel l'une au moins des deux extrémités (31, 32) d'au moins un mât, de préférence de chaque mât, est montée sur la structure porteuse (4) par l'intermédiaire d'un actuateur (5) configuré pour appliquer une torsion au mât que forme l'organe de liaison (3).

15. Système d'intégration (10) selon l'une quelconque des trois revendications précédentes, comprenant en outre, chaque sous-module (2A, 2B, etc.) présentant une extrémité libre (21) à l'opposé d'une seconde extrémité (22) par laquelle s'étend l'organe de liaison (3), un système de verrouillage (9) du mouvement des extrémités libres (21) des sous-modules (2A, 2B, etc.) entre elles et relativement à la structure porteuse (4).

## Patentansprüche

1. Fotovoltaikmodul (1), umfassend:
- ein Substrat (11) und
- eine Vielzahl von Fotovoltaikzellen (12), die in dem Substrat (11) eingekapselt sind,
wobei das Modul aufweist:
- einen ersten Teil (1A), umfassend die Fotovoltaikzellen (12), die auf mindestens zwei Fotovoltaikuntermodule (2A, 2B, usw.) verteilt sind, die voneinander getrennt sind, und
- einen zweiten Teil (1B), der frei von Fotovoltaikzellen ist und sich von dem ersten Teil (1A) des Moduls erstreckt, um ein Verbindungselement (3) zu bilden, das die Fotovoltaikmodule (2A, 2B, usw.) miteinander verbindet,
wobei das Verbindungselement (3), das zumindest zum Teil von dem Substrat (11) gebildet wird, dazu konfiguriert ist, auf einer Tragestruktur (4) montiert zu werden und eine Biegsamkeit aufzuweisen, so dass eine Verformung des Verbindungselements (3) eine Bewegung von mindestens einem, vorzugsweise mehreren, potentiell jedem der Fotovoltaikmodule (2A, 2B, usw.) ohne Verformung der Fotovoltaikmodule (2A, 2B, usw.) induziert, wobei die Bewegung von der Verformung des Verbindungselements (3) abhängt,
wobei das Modul (1) **dadurch gekennzeichnet ist, dass** das Verbindungselement (3) sich gemäß einer bestimmten Hauptrichtung D erstreckt, wobei die Verformung des Verbindungselements eine Verdrehung des Verbindungselements mit einem Drehmoment umfasst, das in der Hauptrichtung D wirkt.

2. Fotovoltaikmodul (1) nach dem vorhergehenden Anspruch, wobei das Verbindungselement (3) mindestens eine Vielzahl von Vorsprüngen (3A, 3B, usw.), die sich jeweils von einem Fotovoltaikuntermodul (2A, 2B, usw.) erstrecken, und einen Teil umfasst, der einen Mast bildet, von dem mindestens eines von zwei Enden (31, 32, usw.) dazu konfiguriert ist, auf der Tragestruktur (4) montiert zu werden, wobei jeder Vorsprung sich gegebenenfalls erstreckt, bis er den Mast erreicht.

3. Fotovoltaikmodul (1) nach einem der vorhergehenden Ansprüche, wobei für dieselbe Verformung des Verbindungselements (3) die Bewegung von mindestens einem Untermodul (2A, 2B, usw.), sogar jedem Untermodul unterschiedlich ist, jedoch von einer Bewegung eines anderen Untermoduls (2A, 2B, usw.), sogar jedem anderen Untermodul abhängt.

4. Fotovoltaikmodul (1) nach einem der vorhergehenden Ansprüche, das derart konfiguriert ist, dass eine Verformung durch Verdrehung des Verbindungselements (3) um seine Erstreckungshauptrichtung D eine Drehung der Fotovoltaikuntermodule (2A, 2B, usw.) um diese Richtung mit sich bringt.

5. Fotovoltaikmodul (1) nach einem der vorhergehenden Ansprüche, wobei das Verbindungselement (3) mindestens einen Mast bildet, von dem mindestens eines von zwei Enden (31, 32) dazu vorgesehen ist, auf der Tragestruktur (4) montiert zu werden.

6. Fotovoltaikmodul (1) nach einem der vorhergehenden Ansprüche, wobei das Verbindungselement (3) eine Funktion einer mechanischen Verbindung der Untermodule (2A, 2B, usw.) miteinander und eine Funktion einer elektrischen Verbindung der Fotovoltaikzellen (12) untereinander und/oder der Untermodule (2A, 2B, usw.) miteinander aufweist.

7. Fotovoltaikmodul (1) nach einem der vorhergehenden Ansprüche, weiterhin umfassend Elektrizität leitende Bahnen, die in dem Substrat (11) eingekapselt sind und sich zwischen dem ersten und dem zweiten Teil (1A, 1B) des Moduls erstrecken, um die Fotovoltaikzellen (12) in Reihe oder parallel miteinander zu verbinden und die Verbindung des Moduls (1) mit mindestens einer externen Verbindungstechnik an dem Modul, wie einer Verbindungsdose, zu ermöglichen.

8. Fotovoltaikmodul (1) nach einem der vorhergehenden Ansprüche, wobei der erste Teil (1A) des Moduls sich auf einer einzigen Seite des zweiten Teils (1B) des Moduls erstreckt.

9. Fotovoltaikmodul (1) nach einem der vorhergehenden Ansprüche, weiterhin umfassend mindestens zwei Verstärkungsdrähte (61, 62), die im Wesentlichen parallel zueinander sind und sich über eine gesamte Länge des Verbindungselements (3), sogar darüber hinaus erstrecken.

10. Fotovoltaikmodul (1) nach einem der vorhergehenden Ansprüche, wobei das Verbindungselement (3) weiterhin mindestens ein Steuerelement (7) mit lokaler Steifigkeit umfasst, das ausgewählt ist aus:
a. einer Materialentfernung (71), um die Steifigkeit des Verbindungselements lokal zu verringern,
b. einem Einsatz (72), wie einem Film, einem Flicken oder einem Stab, um die Steifigkeit des Verbindungselements lokal zu verstärken.

11. Verfahren zur Herstellung eines Fotovoltaikmoduls (1) nach einem der Ansprüche 1 bis 10, **dadurch gekennzeichnet, dass** es einen einzigen Laminierungsschritt umfasst, der dazu konfiguriert ist, die Fotovoltaikzellen (12) in dem Substrat (11) einzukapseln und mindestens einen von dem ersten und dem zweiten Teil (1A, 1B) des Fotovoltaikmoduls (1) zu bilden.

12. System (10) zur Integration von Fotovoltaikkomponenten an einem Gebäude, vorzugsweise an einer Gebäudefassade, umfassend eine Vielzahl von Fotovoltaikmodulen (1) nach einem der Ansprüche 1 bis 10 und eine Tragestruktur (4), die dazu vorgesehen ist, auf dem Gebäude, vorzugsweise auf der Gebäudefassade montiert zu werden.

13. Integrationssystem (10) nach dem vorhergehenden Anspruch, wobei das Verbindungselement (3) von mindestens einem Modul (1), vorzugsweise von jedem Modul einen Mast bildet, von dem mindestens eines von zwei Enden (31, 32) auf der Tragestruktur (4) montiert wird.

14. Integrationssystem (10) nach dem vorhergehenden Anspruch, wobei das eine von mindestens zwei Enden (31, 32) von mindestens einem Mast, vorzugsweise von jedem Mast auf der Tragestruktur (4) mittels eines Aktuators (5) montiert wird, der dazu konfiguriert ist, eine Verdrehung auf den Mast, der das Verbindungselement (3) bildet, anzuwenden.

15. Integrationssystem (10) nach einem der drei vorhergehenden Ansprüche, weiterhin umfassend für jedes Untermodul (2A, 2B, usw.), das ein freies Ende (21) entgegengesetzt zu einem zweiten Ende (22) aufweist, durch das sich das Verbindungselement (3) erstreckt, ein System (9) zur Blockierung der Bewegung von freien Enden (21) von Untermodulen (2A, 2B, usw.) untereinander und in Bezug auf die Tragestruktur (4).

## Claims

1. Photovoltaic module (1) comprising:
- a substrate (11), and
- a plurality of photovoltaic cells (12) encapsulated in the substrate (11),
the module having:
- a first part (1A) comprising the photovoltaic cells (12) divided into at least two photovoltaic sub-modules (2A, 2B, etc.) that are disjoint from one another, and
- a second part (1B) free of photovoltaic cells and extending from the first part (1A) of the module to form a connecting member (3) joining the photovoltaic sub-modules (2A, 2B, etc.) to one another,
the connecting member (3), at least partially formed by the substrate (11), being configured to be mounted on a supporting structure (4) and to have a flexibility such that a deformation of the connecting member (3) induces a movement of at least one, preferably of several, potentially of each, of the photovoltaic sub-modules (2A, 2B, etc.), without deforming the photovoltaic sub-modules (2A, 2B, etc.), said movement being a function of the deformation of the connecting member (3),
the module (1) being **characterised in that**, since the connecting member (3) extends in a determined main direction D, the deformation of the connecting member comprises a twisting of the connecting member with a moment of force acting in said main direction D.

2. Photovoltaic module (1) according to the preceding claim, wherein the connecting member (3) comprises at least a plurality of protrusions (3A, 3B, etc.), each extending from a photovoltaic sub-module (2A, 2B, etc.) and a part forming a pole, at least one of the two ends (31, 32) whereof is configured to be mounted on the supporting structure (4), each protrusion extending, where appropriate, as far as to join the pole.

3. Photovoltaic module (1) according to any one of the preceding claims, wherein, for the same deformation of the connecting member (3), the movement of at least one sub-module (2A, 2B, etc.), or of each sub-module, is different from, but dependent on, a movement of one other sub-module (2A, 2B, etc.), or even of each other sub-module.

4. Photovoltaic module (1) according to any one of the preceding claims, configured such that a torsional deformation of the connecting member (3) about the main direction of extension D thereof causes the photovoltaic sub-modules (2A, 2B, etc.) to rotate about that direction.

5. Photovoltaic module (1) according to any one of the preceding claims, wherein the connecting member (3) forms at least one pole, at least one of the two ends (31, 32) whereof is intended to be mounted on the supporting structure (4).

6. Photovoltaic module (1) according to any one of the preceding claims, wherein the connecting member (3) has a function of mechanically connecting the sub-modules (2A, 2B, etc.) to one another and a function of electrically connecting the photovoltaic cells (12) to one another and/or the sub-modules (2A, 2B, etc.) to one another.

7. Photovoltaic module (1) according to any one of the preceding claims, further comprising electrically conductive tracks encapsulated in the substrate (11) and extending between the first and second parts (1A, 1B) of the module in order to interconnect the photovoltaic cells (12), either in series or in parallel, and to allow for connection of the module (1) to at least one connector external to the module such as a junction box.

8. Photovoltaic module (1) according to any one of the preceding claims, wherein the first part (1A) of the module extends on one side only of the second part (1B) of the module.

9. Photovoltaic module (1) according to any one of the preceding claims, further comprising at least two reinforcing cables (61, 62) substantially parallel to one another and extending over an entire length of the connecting member (3) or even beyond.

10. Photovoltaic module (1) according to any one of the preceding claims, wherein the connecting member (3) further comprises at least one local stiffness controlling element (7) selected from among:
a. A removal of material (71) to locally decrease the stiffness of the connecting member,
b. an insert (72), such as a film, a patch or a bar, to locally increase the stiffness of the connecting member.

11. Method for manufacturing a photovoltaic module (1) according to any one of claims 1 to 10, **characterised in that** it comprises a single lamination step configured to encapsulate the photovoltaic cells (12) in the substrate (11) and to form at least said first and second parts (1A, 1B) of the photovoltaic module (1).

12. Integration system (10) for integrating photovoltaic components into a building, preferably into a building facade, comprising a plurality of photovoltaic modules (1) according to any one of claims 1 to 10, and a supporting structure (4) intended to be attached to the building, preferably to the building facade.

13. Integration system (10) according to the preceding claim, wherein the connecting member (3) of at least one module (1), preferably of each module, forms a pole, at least one of the two ends (31, 32) whereof is mounted on the supporting structure (4).

14. Integration system (10) according to the preceding claim, wherein at least one of the two ends (31, 32) of at least one pole, preferably of each pole, is mounted on the supporting structure (4) via an actuator (5) configured to apply twisting to the pole formed by the connecting member (3).

15. Integration system (10) according to any one of the preceding three claims, further comprising, with each sub-module (2A, 2B, etc.) having a free end (21) opposite a second end (22) through which the connecting member (3) extends, a system (9) for locking the movement of the free ends (21) of the sub-modules (2A, 2B, etc.) relative to one another and relative to the supporting structure (4).
